(19) Europäisches Patentamt
European Patent Office
Office européen des brevets

(11) **EP 2 618 489 A1**

(12) **EUROPEAN PATENT APPLICATION**
published in accordance with Art. 153(4) EPC

(43) Date of publication:
**24.07.2013  Bulletin 2013/30**

(21) Application number: **12830865.7**

(22) Date of filing: **20.09.2012**

(51) Int Cl.:
*H03K 19/086* (2006.01)    *H03K 19/0175* (2006.01)

(86) International application number:
**PCT/JP2012/005963**

(87) International publication number:
**WO 2013/054474 (18.04.2013 Gazette 2013/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.10.2011  JP 2011226669**

(71) Applicant: **Asahi Kasei Microdevices Corporation Tokyo 101-8101 (JP)**

(72) Inventor: **FUCHIGAMI, Nobumitsu Tokyo 101-8101 (JP)**

(74) Representative: **HOFFMANN EITLE Patent- und Rechtsanwälte Arabellastrasse 4 81925 München (DE)**

(54)    **OUTPUT BUFFER CIRCUIT**

(57)    There is provided an output buffer circuit which can reduce the time differences of the rise time and fall time of the output voltages of a differential output signal and, furthermore, can make the rise time and fall time match with a good precision. To the resistance elements R1, R2, PMOS transistors Tr5, Tr6 are connected in parallel. At this time, if designating the resistance components of the resistance elements R1, R2 as r1($\Omega$), r2($\Omega$), designating the resistance components of the PMOS transistors Tr5, Tr6 as rTr5($\Omega$) and rTr6($\Omega$), and designating the resistance component of the current source I1 as rI1($\Omega$), the conditions of (r1//rTr5)= (r2//rI1) and (r2//rTr6)=(r1//rI1) are satisfied. Due to this, the time differences between the rise time and fall time of the output voltages can be reduced and, furthermore, the rise time and fall time can be made to precisely match.

FIG. 1

**Description**

Technical Field

The present invention relates to an output buffer circuit, more particularly relates to an output buffer circuit such as an ECL (Emitter Coupled Logic) circuit or a CML (Current Mode Logic) circuit.

Background Art

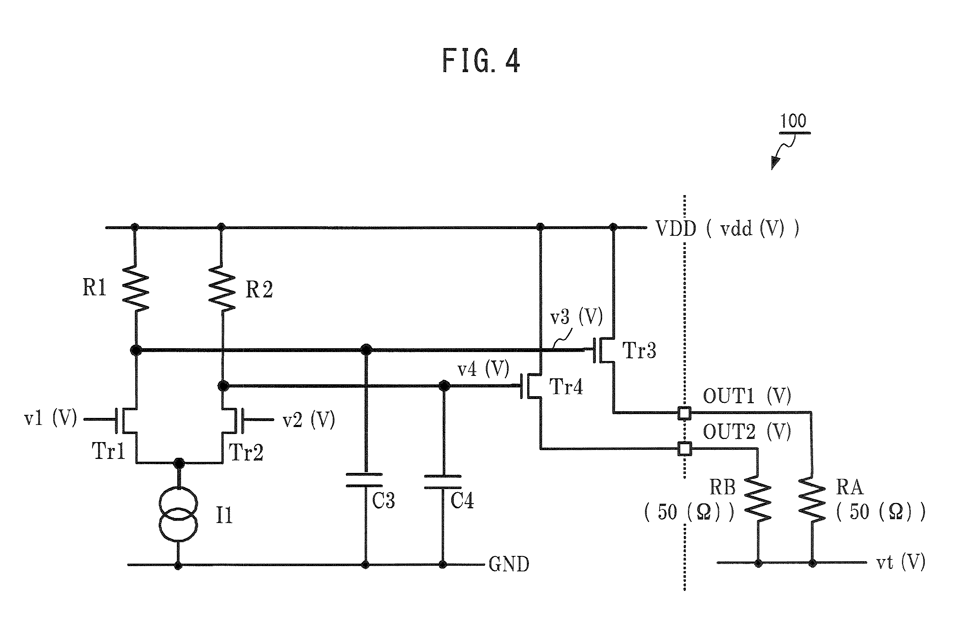

Until now, as an output buffer circuit for high speed data communication use etc., an output buffer circuit such as an ECL circuit or CML circuit has been used. As a specific output buffer circuit, there is an ECL circuit of the following Patent Document 1.
First, referring to FIG. 4, the circuit configuration of a general ECL circuit 100 will be explained.
The ECL circuit 100 shown in FIG. 4 is configured provided with NMOS transistors Tr1 to Tr4, resistance elements R1, R2, a current source I1, and external resistances RA, RB.
The ECL circuit 100 uses the two transistors of the NMOS transistors Tr1, Tr2 to constitute a differential pair. Further, between the drain terminals of the NMOS transistors Tr1, Tr2 and the power source VDD, as loads, the resistance elements R1, R2 are connected. Further, between the source terminals of the NMOS transistors Tr1, Tr2 and the ground GND, the current source I1 is connected as a current supply element. At the gate terminals of the NMOS transistors Tr1, Tr2, differential input voltages v1(V), v2(V) are input. Further, drain terminals of the NMOS transistors Tr1, Tr2 are connected to the gate terminals of the NMOS transistors Tr3, Tr4.
In addition, drain terminals of the NMOS transistors Tr3, Tr4 are connected to a power source VDD. Further, from the source terminals of the NMOS transistors Tr3, Tr4, output voltages OUT1(V), OUT2(V) are output. Note that, the NMOS transistors Tr3, Tr4 constitute a source follower as an output stage. Furthermore, the source terminals of the NMOS transistors Tr3, Tr4 are terminated at a predetermined voltage vt through external resistances RA, RB with resistance components of 50($\Omega$).
Additionally, the capacitors C3, C4 are capacitors of parasitic capacitances at the gate terminals of the NMOS transistors Tr3, Tr4.
Here, the resistance component of the resistance element R1 is designated as "r1($\Omega$)", the current of the current source I1 is designated as "i1(A)", and the voltage of the power source VDD is designated as vdd(V). Then, to make the conduction state of the NMOS transistor Tr1 the on state and make the conduction state of the NMOS transistor Tr2 the off state, the voltages v3(V), v4(V) of the gate terminals of the NMOS transistors Tr3, Tr4 to which the differential input voltages v1(V), v2(V) are input can be expressed as follows:

$$v3 = vdd - r1 \times i1 \quad \text{formula (1)}$$

$$v4 = vdd \quad \text{formula (2)}$$

The NMOS transistors Tr3, Tr4 output currents according to the voltages v3(V), v4(V) of the above formula (1) and formula (2). Further, the currents are converted to output voltages OUT1 (V), OUT2 (V) by the external resistances RA, RB with the resistance components of 50($\Omega$).
The rise time and fall time of the output voltages of a differential output signal are determined by the switching times of the NMOS transistors Tr3, Tr4. That is, the rise time and fall time of the output voltages of a differential output signal are determined by the rise time and fall time of voltages v3(V), v4(V) of the gate terminals of the NMOS transistors Tr3, Tr4.
The rise time Tra (sec) of an output voltage OUT1 (V) of a differential output signal is determined by a time constant of a resistance component r1($\Omega$) of the resistance element R1 and a capacity component c3 (F) of the capacitor C3 at the gate terminal of the NMOS transistor Tr3. Further, the rise time Trb(sec) of an output voltage OUT2 (V) is determined by a time constant of a resistance component r2($\Omega$) of the resistance element R2 and a capacity component c4(F) of the capacitor C4 at the gate terminal of the NMOS transistor Tr4. For this reason, the rise time Tra(Sec), Trb (Sec) of the output voltages of a differential output signal can be expressed as follows:

$$Tra \propto r1 \times c3 \quad \text{formula (3a)}$$

$$Trb \propto r2 \times c4 \quad \text{formula (3b)}$$

Further, the fall time Tfa(Sec) of the output voltage OUT1(V) of a differential output signal is determined by a time constant between a combined resistance component (r1//rl1) ($\Omega$) of a resistance component rl1($\Omega$) of the current source I1 and a resistance component r1($\Omega$) of the resistance element R1 and a capacity component c3 (F) of a capacitor C3 at a gate terminal of the NMOS transistor Tr3. Further, the fall time Tfb (Sec) of the output voltage OUT2 (V) is determined by a time constant between a combined resistance component (r2//rl1) of a resistance component rl1 of the current source I1 and the resistance element R2 and a capacity component c4(F) of a capacitor C4 at a gate terminal of the NMOS transistor Tr4. For this reason, the fall time Tfa(Sec), Tfb(Sec) of the output voltages of the differential output signal can be expressed as follows:

$$Tfa \propto (r1//rI1) \times c3 \quad \text{formula (4a)}$$

$$Tfb \propto (r2//rI1) \times c4 \quad \text{formula (4b)}$$

Prior Art Documents

Patent Documents

Patent Document 1: JP H10-190440 A1

Summary of Invention

Problem to be Solved

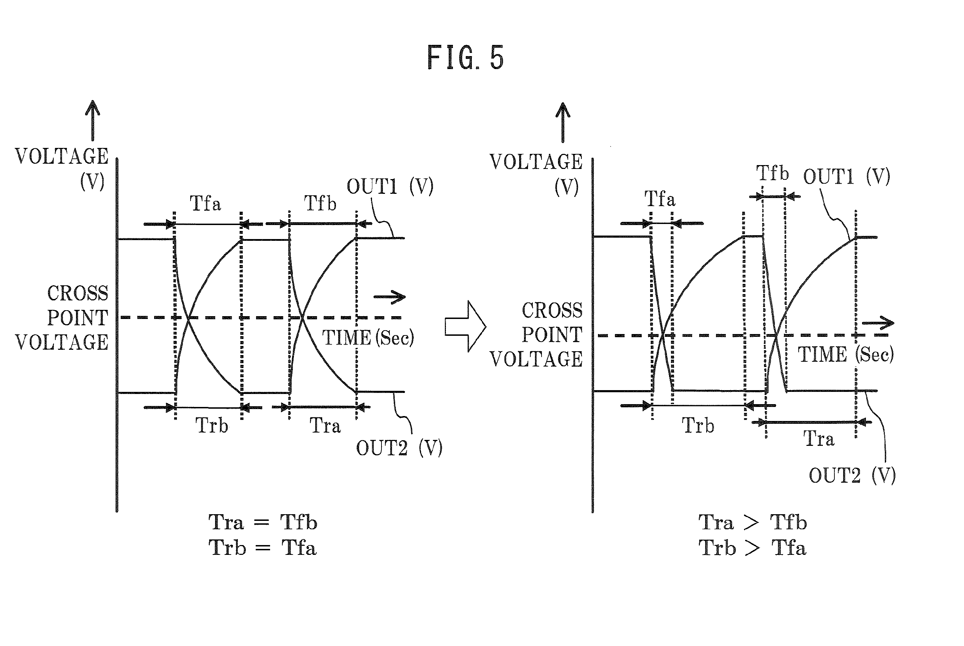

In this regard, in the above ECL circuit 100, the relations of the rise time Tra(Sec), Trb(Sec) of the output voltages of the above formula (3a) and formula (3b) and the fall time Tfa(Sec), Tfb(Sec) of the output voltages of the above formula (4a) and formula (4b) ideally become, as shown in FIG. 5, Tra=Tfb and Trb=Tfa. That is, the cross point voltage of the output voltages OUT1(V), OUT2(V) of a differential output signal of the ECL circuit 100 should become exactly the center of amplitude of the differential output signal.

However, in practice, when setting r1=r2, r1>(rl1//r2) and r2>(rl1//r1), so the relation of the rise time Tra(Sec) of the output voltage OUT1 (V) and the fall time Tfb(Sec) of the output voltage OUT2(V) becomes Tra>Tfb. Further, the relation between the rise time Trb(Sec) of the output voltage OUT2(V) and the fall time Tfa(Sec) of the output voltage OUT1(V) becomes Trb>Tfa. It is to be noted that the resistance elements R1, R2 become load resistances of the differential circuit, so in general r1=r2 may be considered.

Then, it is understood that the cross point voltage when Tra>Tfb, Trb>Tfa shown by the broken line in FIG. 5 becomes lower than the cross point voltage when Tra=Tfb, Trb=Tfa and deviates from the center of the amplitude of the differential output signal.

In this way, in the conventional buffer circuit, there is a problem in that the rise time and fall time of the output voltages of a differential output signal of the output buffer circuit do not match.

Therefore, the present invention has been made in consideration of the above problem and has an object to provide an output buffer circuit capable of reducing a time difference between rise time and fall time output voltages of a differential output signal, and in addition, capable of making rise time and fall time precisely match.

Solution to the Problem

The buffer circuit according to the present invention is configured as follows to achieve the above object.
According to an aspect of the present invention, there is provided an output buffer circuit comprising: a first and second transistors which constitute a differential pair; a first resistance component connected in common to the first and second transistors; first and second resistance elements respectively connected in series to the first and second transistors as loads of the first and second transistors; a second resistance component connected in parallel to the first resistance element and controlled by an input voltage of a gate terminal of the first transistor; and a third resistance component connected in parallel to the second resistance element and controlled by an input voltage of a gate terminal of the second transistor.

With such a configuration, the first resistance element has a second resistance component connected to it in parallel, while the second resistance element has a third resistance component connected to it in parallel. Originally, the resistance components for determining the rise time of the output voltages of a differential output signal are the resistance component of the first resistance element and the resistance component of the second resistance element. On the other hand, the resistance components for determining the fall time of the output voltages of a differential output signal are a combined resistance component of the resistance component of the first resistance element and the first resistance component and a combined resistance components of the resistance component of the second resistance element and the first resistance component.

Therefore, by connecting the second resistance component and the third resistance component, the second resistance component and the third resistance component are added to the resistance components for determining the rise time of the output voltages of a differential output signal. In addition, the relations of the resistance components of these elements can be used for adjustment so that the rise time and fall time of the output voltages of a differential output signal become equal.

In the above output buffer circuit, a difference between a combined resistance component of a resistance component of the first resistance element and the second resistance component and a combined resistance component of a resistance component of the second resistance element and the first resistance component may be adjusted to be smaller, and a difference between a combined resistance component of a resistance component of the second resistance element and the third resistance component and a combined resistance component of a resistance component of the first resistance element and the first resistance component may be adjusted to be smaller.

By doing this, when designating the resistance components of the first and second resistance elements as r1 ($\Omega$) and r2($\Omega$), designating the second and third resistance components as rTr5($\Omega$) and rTr6($\Omega$), and designating the first resistance component as rl1 ($\Omega$), by using the second and third resistance components, the difference between (r1//rTr5) and (r2//rl1) is reduced without limit. In the same way, the difference between (r2//rTr6) and (r1//rl1) also becomes smaller without limit.

Thus, the difference between (r1//rTr5) and (r2//rl1) when using the second resistance component becomes extremely small compared with the difference between r1 and (r2//rl1) when not using the second resistance component. Further, the difference between (r2//rTr6) and (r1//rl1) when using the third resistance component becomes extremely small compared with the difference between r2 and (r1//rl1) when not using the third resistance component. Accordingly, it becomes possible to reduce the time difference between the rise time and fall time of output voltages of a differential output signal.

In the above output buffer circuit, preferably, a combined resistance component of a resistance component of the first resistance element and the second resistance component and a combined resistance component of a resistance component of the second resistance element and the first resistance component are equal or substantially equal, and a combined resistance component of a resistance component of the second resistance element and the third resistance component and a combined resistance component of a resistance component of the first resistance element and the first resistance component are equal or substantially equal.

Thus, the conditions (r1//rTr5)= (r2//rl1) and (r2//rTr6) = (r1//rl1) are satisfied. Due to this, it becomes possible to reduce the time differences between the rise time and fall time of the output voltages of a differential output signal and, furthermore, the rise time and fall time can be made to match with a good precision.

In the above output buffer circuit, the first resistance component may be provided with a current supply element which supplies current to the first and second transistors, the second resistance component may be provided with a first adjustment-use transistor with a gate terminal connected to a gate terminal of the first transistor, and the third resistance component may be provided with a second adjustment-use transistor with a gate terminal connected to a gate terminal of the second transistor.

In addition, in the above output buffer circuit, the second resistance component may be provided with a first adjustment-use resistance element connected in series to the first adjustment-use transistor, and the third resistance component may be provided with a second adjustment-use resistance element connected in series to say second adjustment-use transistor.

Thus, furthermore, the first adjustment-use resistance element is serially connected to the first adjustment-use transistor and is connected together with the first adjustment-use transistor in parallel to the first resistance element. In the same way, the second adjustment-use resistance element is serially connected to the second adjustment-use transistor and is connected together with the second adjustment-use transistor in parallel to the second resistance element.

Accordingly, the resistance component of the first adjustment-use resistance element and the resistance component of the second adjustment-use resistance element are added to the resistance components for determining the rise time of the output voltages of a differential output signal. Further, it becomes possible to use the resistance components of the elements for adjustment so that the rise time and fall time of the output voltages of a differential output signal to become the same.

In the above output buffer circuit, a difference between a combined resistance component of a resistance component of the first resistance element and a resistance component of the first adjustment-use resistance element and a combined resistance component between a resistance component of the second resistance element and the first resistance component may be adjusted to be smaller, and a difference between a combined resistance component of a resistance component of the second resistance element and a resistance component of the second adjustment-use resistance element and a combined resistance component of a resistance component of the first resistance element and the first resistance component may be adjusted to be smaller.

Thus, when designating the resistance components of the first and second resistance elements as r1($\Omega$), r2($\Omega$), designating the resistance components of the first and second adjustment-use resistance elements as r3($\Omega$), r4($\Omega$), and designating the resistance component of the current supply element as r5($\Omega$), by using the first and second adjustment-use transistors, the difference between (r1//r3) and (r2//r5) is reduced without limit. Furthermore, the difference between the (r2//r4) and (r1//r5) is reduced without limit.

Accordingly, the difference between (r1//r3) and (r2//r5) when using the first adjustment-use resistance element becomes extremely small compared with the difference between r1 and (r2//r5) when not using the first adjustment-use resistance element. Further, the difference between the (r2//r4) and (r1//r5) when using the second adjustment-use resistance element becomes extremely small compared with the difference between r2 and (r1//r5) when not using the first adjustment-use resistance element. Accordingly, it becomes possible to reduce the time differences between the rise time and fall time of the output voltages of a differential output signal.

In the above output buffer circuit, preferably, a combined resistance component of a resistance component of the first resistance element and a resistance component of the first adjustment-use resistance element and a combined resistance component of a resistance component of the second resistance element and the first resistance component are equal or substantially equal, and a combined resistance component of a resistance component of the second resistance element and a resistance component of the second adjustment-use resistance element and a combined resistance component of a resistance component of the first resistance element and the first resistance component are equal or substantially equal.

Thus, the conditions of (r1//r3)=(r2//r5), (r2//r4)=(r1//r5) are satisfied. Due to this, it becomes possible to reduce the time difference between the rise time and fall time of the output voltages of a differential output signal and furthermore possible to make the rise time and fall time precisely match.

In the above output buffer circuit, the current supply element may be a constant current source. When the current supply element is configured to be a constant current source, the above explained relation of the constant current source, first adjustment-use transistor, second adjustment-use transistor, and the first resistance element and second resistance element in resistance components can be used to adjust the rise time and fall time of the output voltages of a differential output signal.

In the above output buffer circuit, the current supply element may be a resistance element. When the current supply element is configured to be a current source, for example the first adjustment-use transistor and the second adjustment-use transistor are PMOS transistors, while the current source I1 is an NMOS transistor. Accordingly, since these transistors are not the same transistors, when there are inherent variations in these transistors at the time of production, these variations do not become the same.

However, by configuring the current supply element to be a resistance element the same as the first adjustment-use resistance element and the second adjustment-use resistance element, it is made possible to make the variation among resistances relatively the same. Due to this, it becomes possible to reduce the effects of deviation between the rise time and fall time of the output voltages of a differential output signal due to variations at the time of production in the elements forming the circuit.

In the above output buffer circuit, a source follower may be provided as an output stage. Accordingly, even with a CML circuit of a circuit configuration not having a source follower as an output stage, it becomes possible to reduce the effect of deviation between the rise time and fall time of output voltages of a differential output signal.

Advantageous Effects of the Invention

According to the output buffer circuit of the present invention, the time difference between the rise time and fall time of the output voltages of a differential output signal can be reduced. Furthermore, the rise time and fall time of the output voltages of a differential output signal can be made to precisely match.

Brief Description of the Drawings

FIG. 1 is a circuit diagram which shows a circuit configuration of an ECL circuit 10 according to a first embodiment of the present invention;

FIG. 2 is a circuit diagram which shows a circuit configuration of an ECL circuit 20 according to a second embodiment of the present invention;

FIG. 3 is a circuit diagram which shows a circuit configuration of an ECL circuit 30 according to a third embodiment of the present invention;

FIG. 4 is a circuit diagram which shows a circuit configuration of a conventional ECL circuit 100; and

FIG. 5 is a graph which shows output voltages OUT1(V), OUT2 (V) of a differential output signal of a conventional ECL circuit 100.

Description of Embodiments

Hereinafter, while referring to the attached drawings, preferred embodiments of a buffer circuit of the present invention will be explained in detail.

(Circuit Configuration and Operation of ECL Circuit 10 According to First Embodiment)

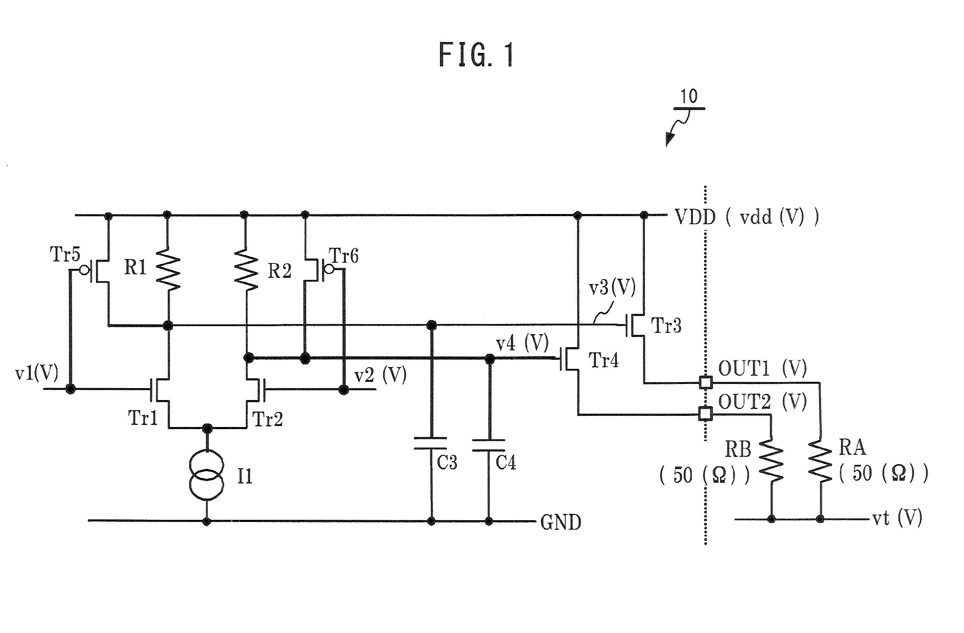

First, referring to FIG. 1, the circuit configuration and operation of an ELC circuit 10 according to a first embodiment of the present invention will be explained.

The ECL circuit 10 (output buffer circuit) shown in FIG. 1 constitutes a differential pair by two transistors of NMOS transistors Tr1, Tr2 (first and second transistors). In addition, between the drain terminals of the NMOS transistors Tr1, Tr2 and a power source VDD, as loads, resistance elements R1, R2 (first and second resistance elements) are connected. Further, between the source terminals of the NMOS transistors Tr1, Tr2 and the ground GND, as a current supply element, a current source I1 (first resistance component, current supply element, or constant current source) is connected. At the gate terminals of the NMOS transistors Tr1, Tr2, differential input voltages v1(V), v2(V) (input voltages) are input. Furthermore, the drain terminals of the NMOS transistors Tr1, Tr2 are connected to the gate terminals of the NMOS transistors Tr3, Tr4.

Moreover, the drain terminals of the NMOS transistors Tr3, Tr4 are connected to the power source VDD. Additionally, from the source terminals of the NMOS transistors Tr3, Tr4, output voltages OUT1(V) and OUT2 (V) are output. Note that, the NMOS transistors Tr3, Tr4 constitute a source follower as an output stage. Further, the source terminals of the NMOS transistors Tr3, Tr4 are terminated at a predetermined voltage vt through external resistances RA and RB with resistance components of 50(Ω).

Further, the capacitors C3, C4 are capacitors of parasitic capacitances at the gate terminals of the NMOS transistors Tr3, Tr4.

The ECL circuit 10 differs from the conventional ECL circuit 100 in the point of having PMOS transistors Tr5, Tr6 which function as adjustment-use transistors.

The PMOS transistor Tr5 which functions as this adjustment-use transistor (second resistance component or first adjustment-use transistor) is connected in parallel to the resistance element R1. On the other hand, the PMOS transistor Tr6 (third resistance component or second adjustment-use transistor) is connected in parallel to the resistance element R2. That is, the drain terminals and source terminals of the PMOS transistors Tr5, Tr6 have the two ends of the resistance elements R1, R2 connected to them. Further, the gate terminals of the PMOS transistors Tr5, Tr6 have gate terminals of the NMOS transistors Tr1, Tr2 connected to them and have differential input voltages v1(V), v2(V) input to them.

In the ECL circuit 10 according to this first embodiment, the rise time Tra(Sec) of the output voltage OUT1(V) of the differential output signal is determined by the time constant of the combined resistance component (r1//rTr5)(Ω) of the resistance component r1(Ω) of the resistance element R1 and the resistance component rTr5(Ω) of the on resistance RTr5 of the PMOS transistor Tr5 and the capacity component c3 (F) of the capacity C3 at the gate terminal of the NMOS transistor Tr3. In addition, the rise time Trb(Sec) of the output voltage OUT2(V) is determined by the time constant of the combined resistance component (r2//rTr6) of the resistance component r2(Ω) of the resistance element R2 and the resistance component rTr6(Ω) of the on resistance RTr6 of the PMOS transistor Tr6 and the capacity component c4 (F) of the capacitor C4 at the gate terminal of the NMOS transistor Tr4. For this reason, the rise time Tra(Sec), Trb(Sec) of the output voltages can be expressed as follows:

$$Tra \propto (r1//rTr5) \times c3 \quad \text{formula (5a)}$$

$$Trb \propto (r2//rTr6) \times c4 \quad \text{formula (5b)}$$

On the other hand, the fall time Tfa(Sec), Tfb(Sec) of the output voltages are not different from formula (4a) and formula (4b) which have already been explained above.

That is, if the resistance components of the elements become the relation such as shown in the following formula (6) and become the relation such as shown in formula (7), it becomes possible to reduce the time differences between the rise time and fall time of the output voltages and make the rise time and fall time precisely match.

The above Tra depends on (r1//rTr5), the Trb depends on (r2//rTr6), Tfa depends on (r1//rl1), and Tfb depends on (r2//rl1). For this reason, to make the relation between the rise time of the output voltage OUT1 (V) and the fall time of the output voltage OUT2 (V) Tra=Tfb, it is sufficient to make

$$(r1//rTr5) = (r2//rI1) \quad \text{formula (6)}$$

In the same way, to make the relation between the rise time of the output voltage OUT2 (V) and the fall time of the output voltage OUT1(V) Trb=Tfa, it is sufficient to make

$$(r2//rTr6) = (r1//rI1) \quad \text{formula (7)}$$

At this time, the values of the resistance component r1($\Omega$) and the resistance component r2($\Omega$) are made substantially close values, the values of the resistance component rTr5($\Omega$) and the resistance component rl1($\Omega$) are made substantially close values, and, furthermore, the values of the resistance component rTr6($\Omega$) and the resistance component rl1($\Omega$) are made substantially close values. Then, the relation between the rise time Tra(Sec) of the output voltage OUT1(V) and the fall time Tfb(Sec) of the output voltage OUT2(V) becomes Tra≈Tfb. Accordingly, the time difference between the rise time Tra(Sec) and the fall time Tfb(Sec) can be reduced. Further, the relation between the rise time Trb(Sec) of the output voltage OUT2 (V) and the fall time Tfa(Sec) of the output voltage OUT1 (V) becomes Trb≈Tfa. Accordingly, the time difference between the rise time Trb(Sec) and the fall time Tfa(Sec) can be reduced.

Furthermore, the values of the resistance component r1($\Omega$) and the resistance component r2($\Omega$) are made the same values, the values of the resistance component rTr5($\Omega$) and the resistance component rl1 ($\Omega$) are made the same values, and, furthermore, the values of the resistance component rTr6($\Omega$) and the resistance component rl1 ($\Omega$) are made the same values. Then, the relation between the rise time Tra (Sec) and the fall time Tfb(Sec) becomes Tra=Tfb. Accordingly, the time difference between the rise time Tra(Sec) and the fall time Tfb(Sec) can be made to precisely match. Further, the relation between the rise time Trb(Sec) and the fall time Tfa(Sec) becomes Trb=Tfa. Accordingly, the rise time Trb (Sec) and the fall time Tfa (Sec) can be made to precisely match.

In this way, the PMOS transistors Tr5, Tr6 which function as adjustment-use transistors are newly connected to thereby add the resistance components rTr5($\Omega$), rTr6($\Omega$) of the PMOS transistors Tr5, Tr6 to the resistance components for determining the rise time of the output voltages of a differential output signal. Further, the relations of the elements such as shown in the above formula (6) and formula (7) may be used for adjustment so that the rise time and fall time of the output voltages of a differential output signal become the same.

To make the rise time Tra(Sec) of the output voltage OUT1(V) and the fall time Tfb(Sec) of the output voltage OUT2(V) precisely match, the difference between (r1//rTr5) and (r2//rl1) must be made 0. However if using the PMOS transistor Tr5 to adjust the resistance components rTr5, rl1 and make the difference between (r1//rTr5) and (r2//rl1) close to 0 without limit, the time differences between the rise time and fall time of the output voltages can be reduced. In short, the relation between |r1-(r2//rl1)| when there is no PMOS transistor Tr5 and |(r1//rTr5) - (r2//rl1)| when there is the PMOS transistor Tr5 need only to be |r1-(r2//rl1)| >> |(r1// rTr5)-(r2//rl1)|. In the same way, to make the rise time Trb (sec) of the output voltage OUT2 (V) and the fall time Tfa(sec) of the output voltage OUT1(V) precisely match, it is sufficient to use the PMOS transistor Tr6 so as to adjust the resistance components rTr6, rl1 and make |r2-(r1//rl1)|>>| (r2//rTr6)-(r1//rl1)|.

As shown in the graph of FIG. 5, when Tra>Tfb and Trb>Tfa, the cross point voltage of the output voltages OUT1(V), OUT2 (V) differential output signal ended up deviating from the center of amplitude of the differential output signal. However, by using the above procedure for adjustment to Tra=Tfb, Trb=Tfa, it is possible to make the cross point voltage of the output voltages OUT1(V), OUT2(V) of the differential output signals match near the center of the amplitude of the differential output signal.

(Circuit Configuration and Operation of ECL Circuit According to Second Embodiment)

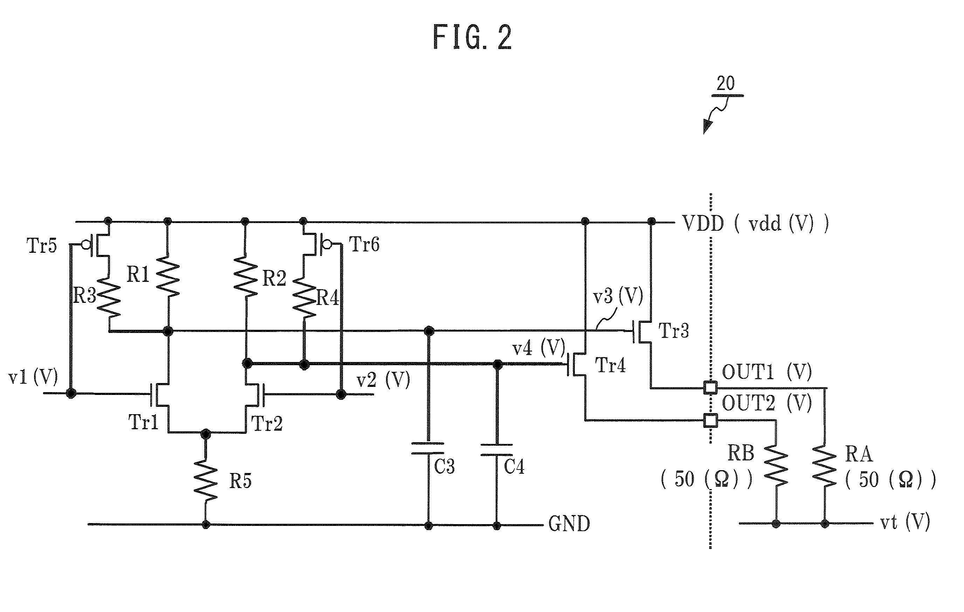

Next, referring to FIG. 2, the circuit configuration and operation of the ECL circuit 20 according to the second embodiment of the present invention will be explained.

The ECL circuit 20 (output buffer circuit) shown in FIG. 2 has the same elements as the elements which constitute the ECL circuit 10 according to the first embodiment which shown in FIG. 1 and has circuit parts which have the same circuit configuration as the ECL circuit 10. However, the ECL circuit 20 differs from the ECL circuit 10 on the point that it further has resistance elements R3, R4 which function as adjustment-use resistance elements and the point that it uses as the element which functions as a current supply element not the current source I1, but the resistance element R5 (first resistance component, current supply element, or resistance element). The resistance element R3 (first adjustment-use resistance element) which functions as this adjustment-use resistance element is connected in series to the PMOS transistor Tr5. At this time, the PMOS transistor Tr5 and the resistance element R3 connected in series are connected in parallel to the resistance element R1. Further, the resistance element R4 (second adjustment-use resistance element) is connected in series to the PMOS transistor Tr6. At this time, the PMOS transistor Tr6 and the resistance element R4 connected in series are connected in parallel to the resistance element R2.

In the same way as the ECL circuit 10 according to the first embodiment, the gate terminals of the PMOS transistors Tr5, Tr6 are connected to gate terminals of the NMOS transistors Tr1, Tr2 and receive as input the differential input voltages v1(V), v2(V). Note that the order of connection of the PMOS transistor Tr5 and the resistance element R3 is not limited to the order of connection shown in FIG. 2. The PMOS transistor Tr5 and the resistance element R3 may also be switched. Further, the same is true for the order of connection of the PMOS transistor Tr6 and the resistance element R4.

Further, in the ECL circuit 20 according to the present embodiment, the source terminals of the NMOS transistors Tr1, Tr2 which constitute the differential pair are connected to not the current source I1, but the resistance element R5 which functions as a current supply element the same as the current source I1.

Here, the resistance component of the resistance element R5 is designated as r5($\Omega$). Then, the voltages v3(V), v4(V) of the gate terminals of the NMOS transistors Tr3, Tr4 when the differential input voltages v1(V), v2(V) are input so that the conduction state of the NMOS transistor Tr1 becomes the on state and the conduction state of the NMOS transistor Tr2 becomes off can be expressed as follows:

$$v3 = (r5/(r1+r5)) \times vdd \quad \text{formula (8)}$$

$$v4 = vdd \quad \text{formula (9)}$$

Due to this, the amplitude of the differential output signal can be adjusted in accordance with the resistance component r1 and the resistance component r5. That is, in the ECL circuit 10 according to the first embodiment, the amplitude of the differential output signal is adjusted by the current source I1 and the resistance element R1 (resistance element R2), but in the ECL circuit 20 according to the present embodiment, the amplitude of the differential output signal can be adjusted in accordance with the divided voltages of the resistance elements.

In the ECL circuit 20 in this second embodiment, the rise time Tra(Sec) of the output voltage OUT1 (V) of the differential output signal is determined by the time constant between the combined resistance component (r1//r3) ($\Omega$) of the resistance component r1($\Omega$) of the resistance element R1 and the resistance component r3($\Omega$) of the resistance element R3 and the capacity component c3(F) of the capacitor C3 at the gate terminal of the NMOS transistor Tr3. Further, the rise time Trb(Sec) of the output voltage OUT2 (V) is determined by the time constant between the combined resistance component (r2//r4)($\Omega$) of the resistance component r2($\Omega$) of the resistance element R2 and the resistance component r4($\Omega$) of the resistance element R4 and the capacity component c4(F) of the capacitor C4 at the gate terminal of the NMOS transistor Tr4. For this reason, the rise time Tra(Sec), Trb(Sec) of the output voltages can be expressed as follows:

$$Tra \propto (r1//r3) \times c3 \quad \text{formula (10a)}$$

$$Trb \propto (r2//r4) \times c4 \quad \text{formula (10b)}$$

On the other hand, the fall time Tfa(Sec) of the output voltage OUT1(V) of the differential output signal is determined by the time constant between the combined resistance component (R1//R5) ($\Omega$) of the resistance component r1 ($\Omega$) of the resistance element R1 and r5 ($\Omega$) of the resistance element R5 and the capacity component c3 (F) of the capacitor C3 at the gate terminal of the NMOS transistor Tr3. Further, the fall time Tfb(Sec) of the output voltage OUT2 (V) is determined by the time constant between the combined resistance component (r2//r5) of the resistance component r2($\Omega$) of the resistance element R2 and the resistance component r5($\Omega$) of the resistance element R5 and the capacity component c4 (F) of the capacitor C4 at the gate terminal of the NMOS transistor Tr4. For this reason, the fall time Tfa (Sec), Tfb(Sec) of the output voltages can be expressed as follows:

$$\mathrm{Tfa} \propto (r1 /\!/ r5) \times c3 \qquad \text{formula (11a)}$$

$$\mathrm{Tfb} \propto (r2 /\!/ r5) \times c4 \qquad \text{formula (11b)}$$

That is, if the resistance components of the elements become the relation such as shown in the following formula (12) and become the relation such as shown in formula (13), it becomes possible to reduce the time difference between the rise time Tra(Sec) and the fall time Tfb(Sec) of the output voltages or to reduce the time difference of the rise time Trb(Sec) and the fall time Tfa(Sec) to make the rise time and fall time precisely match.

$$(r1 /\!/ r3) = (r2 /\!/ r5) \qquad \text{formula (12)}$$

$$(r2 /\!/ r4) = (r1 /\!/ r5) \qquad \text{formula (13)}$$

At this time, the values of the resistance component $r1(\Omega)$ and the resistance component $r2(\Omega)$ are made substantially close values or the values of the resistance component $r3(\Omega)$ and the resistance component $r5(\Omega)$ are made substantially close values and furthermore the values of the resistance component $r4(\Omega)$ and the resistance component $r5(\Omega)$ are made substantially close values. Then, the relation between the rise time Tra (Sec) and the fall time Tfb (Sec) of the output voltages becomes Tra≈Tfb. Accordingly, the time differences between the rise time Tra(Sec) and the fall time Tfb (Sec) of the output voltages can be reduced. Further, the relation between the rise time Trb(Sec) and the fall time Tfa(Sec) of the output voltages becomes Trb≈Tfa. Accordingly, the time differences between the rise time Trb(Sec) and the fall time Tfa(Sec) of the output voltages can be reduced.

Furthermore, the values of the resistance component $r1(\Omega)$ and the resistance component $r2(\Omega)$ are made the same values or the values of the resistance component $r3(\Omega)$ and the resistance component $r5(\Omega)$ are made the same values and furthermore the values of the resistance component $r4(\Omega)$ and resistance component $r5(\Omega)$ are made the same values. By doing this, the relation of the rise time Tra (Sec) and the fall time Tfb(Sec) of the output voltages becomes Tra=Tfb. Accordingly, the rise time Trb (Sec) and the fall time Tfa (Sec) of the output voltages can be made to precisely match. Further, the relation of the rise time Trb(Sec) and the fall time Tfa(Sec) of the output voltages becomes Trb=Tfa. Accordingly, the rise time Trb(Sec) and the fall time Tfa(Sec) of the output voltages can be made to precisely match.

Further, in the ECL circuit 10 according to the first embodiment, the PMOS transistors Tr5, Tr6 which have the resistance components $rTr5(\Omega)$, $rTr6(\Omega)$ as on resistances RTr5, RTr6 are PMOS transistors. Further, the current source I1 which has the resistance component rI1 is an NMOS transistor. In this way, these transistors are not the same types of transistors, so when there is inherent variation in these transistors at the time of production, the variations do not become the same.

In contrast to this, in the ECL circuit 20 according to the present embodiment, the resistance elements R3 to R5 are all the same resistances. For this reason, even if there is inherent variation in the resistance elements at the time of production, the variations become relatively the same no matter which the resistance element. For this reason, the ECL circuit 20 according to the present embodiment has the feature of being resistant to the effects of deviation between the rise time and fall time of the output voltages due to variation at the time of production of elements forming the circuit compared with the ECL circuit 10 according to the first embodiment.

In this way, by newly connecting resistance elements R3, R4 which function as adjustment-use resistance elements, resistance components $r3(\Omega)$, $r4(\Omega)$ of the resistance elements R3, R4 are added to the resistance components for determining the rise time of the output voltages of a differential output signal. Further, by connecting as the current supply element not the current source I1, but the resistance element R5, the resistance components for determining the fall time of the output voltages of a differential output signal are changed to the resistance component $r5(\Omega)$ of the resistance element R5. Further, the relations of resistance components of the elements such as shown in the above formula (12) and formula (13) are used for adjustment so that the rise time and fall time of the output voltages of a differential output signal become the same. In this way, in the ECL circuit 20, the resistance elements R3, R4 which function as adjustment-use resistance elements can be used to adjust the rise time of a differential output signal and the resistance element R5 which functions as the current supply element can be used to adjust the fall time of a differential output signal. Further, since the elements used for adjustment are all resistance elements (resistance elements R3 to R5), the rise time and fall time of a differential output signal can be easily made to match.

(Circuit Configuration and Operation of CML Circuit 30 According to Third Embodiment)

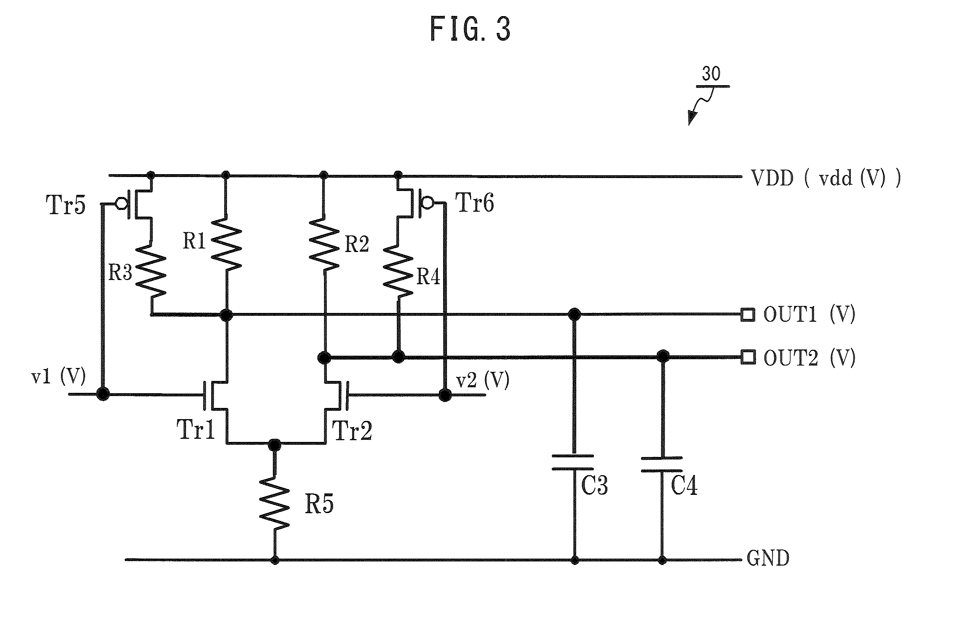

Next, referring to FIG. 3, the circuit configuration and operation of a CML circuit 30 according to a third embodiment of the present invention will be explained.
The CML circuit 30 (output buffer circuit) shown in FIG. 3 is a circuit configuration which does not have just the NMOS transistors Tr3, Tr4 among the elements which constitute the ECL circuit 20 according to the second embodiment. That is, the CML circuit 30 is a circuit configuration which does not have a source follower as an output stage. The CML circuit 30 does not have NMOS transistors Tr3, Tr4, but in circuit operation is the same as the ECL circuit 20 according to the second embodiment. For this reason, the above explained procedure may be used to reduce the time differences between rise time and fall time of the output voltage so as to make the rise time and fall time precisely match. In this way, the output buffer circuit is not limited to an ECL circuit such as explained in the above embodiments and may be a CML circuit.

(Summary of ECL Circuits and CML Circuits According to Embodiments)

In the ECL circuits and CML circuits according to the embodiments, elements which function as adjustment-use transistors and adjustment-use resistance elements are newly connected to thereby add resistance components of the elements to the resistance components for determining the rise time of the output voltages of a differential output signal. In addition, by connecting an element which functions as a current supply element not to just a current source, but also resistance elements, the resistance components for determining the fall time of the output voltages of a differential output signal can also be changed to resistance elements. Further, the relation between the resistance components of the elements such as explained above can be used is adjusted so that the rise time and fall time of the output voltages of a differential output signal become the same.

Industrial Applicability

As an output buffer circuit, in which it is possible to obtain an output buffer circuit which reduces the time differences between the rise time and fall time of the output voltages of a differential output signal, and in addition, it is possible to precisely make the rise time and fall time match, it is possible to utilize for various electronic devices for use in high-speed data communication.

Reference Signs List

| | |
|---|---|
| 10, 20 | ECL circuit (buffer circuit) |
| 30 | CML circuit (buffer circuit) |
| R1, R2 | resistance element |
| Tr1 to Tr4 | NMOS transistor |
| C3, C4 | capacitor element for gate terminals of NMOS transistors Tr3, Tr4 |
| R3, R4 | resistance element (adjustment-use resistance element) |
| Tr5, Tr6 | PMOS transistor (adjustment-use transistor) |
| I1 | current source (current supply element) |
| R5 | resistance element (current supply element) |
| RA, RB | external resistance |

**Claims**

1.  An output buffer circuit comprising:

    first and second transistors which constitute a differential pair;
    a first resistance component connected in common to the first and second transistors;
    first and second resistance elements respectively connected in series to the first and second transistors as loads of the first and second transistors;

a second resistance component connected in parallel to the first resistance element and controlled by an input voltage of a gate terminal of the first transistor; and
a third resistance component connected in parallel to the second resistance element and controlled by an input voltage of a gate terminal of the second transistor.

2. The output buffer circuit according to claim 1, wherein
a difference between a combined resistance component of a resistance component of the first resistance element and the second resistance component and a combined resistance component of a resistance component of the second resistance element and the first resistance component is adjusted to be smaller, and
a difference between a combined resistance component of a resistance component of the second resistance element and the third resistance component and a combined resistance component of a resistance component of the first resistance element and the first resistance component is adjusted to be smaller.

3. The output buffer circuit according to claim 1, wherein
a combined resistance component of a resistance component of the first resistance element and the second resistance component and a combined resistance component of a resistance component of the second resistance element and the first resistance component are equal or substantially equal, and
a combined resistance component of a resistance component of the second resistance element and the third resistance component and a combined resistance component of a resistance component of the first resistance element and the first resistance component are equal or substantially equal.

4. The output buffer circuit according to any one of claims 1 to 3, wherein
the first resistance component is provided with a current supply element which supplies current to the first and second transistors,
the second resistance component is provided with a first adjustment-use transistor with a gate terminal connected to a gate terminal of the first transistor, and
the third resistance component is provided with a second adjustment-use transistor with a gate terminal connected to a gate terminal of the second transistor.

5. The output buffer circuit according to claim 4, wherein
the second resistance component is provided with a first adjustment-use resistance element connected in series to the first adjustment-use transistor, and
the third resistance component is provided with a second adjustment-use resistance element connected in series to the second adjustment-use transistor.

6. The output buffer circuit according to claim 5, wherein
a difference between a combined resistance component of a resistance component of the first resistance element and a resistance component of the first adjustment-use resistance element and a combined resistance component between a resistance component of the second resistance element and the first resistance component is adjusted to be smaller, and
a difference between a combined resistance component of a resistance component of the second resistance element and a resistance component of the second adjustment-use resistance element and a combined resistance component of a resistance component of the first resistance element and the first resistance component is adjusted to be smaller.

7. The output buffer circuit according to claim 5, wherein
a combined resistance component of a resistance component of the first resistance element and a resistance component of the first adjustment-use resistance element and a combined resistance component of a resistance component of the second resistance element and the first resistance component are equal or substantially equal, and
a combined resistance component of a resistance component of the second resistance element and a resistance component of the second adjustment-use resistance element and a combined resistance component of a resistance component of the first resistance element and the first resistance component are equal or substantially equal.

8. The output buffer circuit according to claim 4, wherein the current supply element is a constant current source.

9. The output buffer circuit according to claim 4, wherein the current supply element is a resistance element.

10. The output buffer circuit according to any one of claims 1 to 9, wherein a source follower is provided as an output stage.

# FIG. 1

EP 2 618 489 A1

FIG. 2

FIG. 3

EP 2 618 489 A1

# FIG. 4

EP 2 618 489 A1

FIG. 5

VOLTAGE (V)

OUT1 (V)

Tfb

Tfa

CROSS POINT VOLTAGE

TIME (Sec)

Tra

Trb

OUT2 (V)

Tra = Tfb
Trb = Tfa

VOLTAGE (V)

Tfb OUT1 (V)

Tfa

CROSS POINT VOLTAGE

TIME (Sec)

Tra

Trb

OUT2 (V)

Tra > Tfb
Trb > Tfa

## INTERNATIONAL SEARCH REPORT

| International application No. |
| --- |
| PCT/JP2012/005963 |

A. CLASSIFICATION OF SUBJECT MATTER
*H03K19/086*(2006.01)i, *H03K19/0175*(2006.01)i

According to International Patent Classification (IPC) or to both national classification and IPC

B. FIELDS SEARCHED

Minimum documentation searched (classification system followed by classification symbols)
H03K19/086, H03K19/0175

Documentation searched other than minimum documentation to the extent that such documents are included in the fields searched
Jitsuyo Shinan Koho        1922-1996   Jitsuyo Shinan Toroku Koho   1996-2012
Kokai Jitsuyo Shinan Koho  1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2008-160304 A  (NEC Electronics Corp.),<br>10 July 2008 (10.07.2008),<br>all pages; fig. 1 to 3<br>& US 2008/0150584 A1 | 1-9<br>10 |
| X<br>Y | JP 2-295314 A  (NEC Corp.),<br>06 December 1990 (06.12.1990),<br>all pages; fig. 1<br>(Family: none) | 1-9<br>10 |
| Y | JP 5-14175 A  (Matsushita Electric Industrial Co., Ltd.),<br>22 January 1993 (22.01.1993),<br>all pages; fig. 1, 2<br>(Family: none) | 10 |

☒ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>25 October, 2012 (25.10.12) | Date of mailing of the international search report<br>06 November, 2012 (06.11.12) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/005963

C (Continuation). DOCUMENTS CONSIDERED TO BE RELEVANT

| Category* | Citation of document, with indication, where appropriate, of the relevant passages | Relevant to claim No. |
|---|---|---|
| Y | JP 3-172020 A (Toshiba Corp.), 25 July 1991 (25.07.1991), all pages; fig. 1, 2 (Family: none) | 10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10190440 A